# EUROPÄISCHE PATENTANMELDUNG

(11) **EP 1 710 829 A1**
(43) Veröffentlichungstag der Anmeldung: **11.10.2006**
(21) Anmeldenummer: 05007339.4
(22) Anmeldetag: 05.04.2005
(51) Int. Cl.: H01J 37/34

(54) **Magnetanordnung für ein Planar-Magnetron**

(71) Anmelder: Applied Films GmbH & Co. KG, 63755 Alzenau (DE)
(72) Erfinder: Deppisch, Thomas, 63743 Aschaffenburg (DE); Lopp, Andreas, 63579 Freigericht (DE)
(74) Vertreter: Schickedanz, Willi

(57) **Zusammenfassung**

Die Erfindung betrifft eine Magnetanordnung für ein Planar-Magnetron, bei welcher ein erster Magnetpol einen zweiten Magnetpol umschließt. Diese Magnetanordnung wird linear in Längsrichtung zu einem Target um einen bestimmten Betrag bewegt und dann in entgegen gesetzter Richtung um den gleichen Betrag wieder zurückbewegt. Bei einer Ausführungsform erfolgt auch noch eine Bewegung senkrecht hierzu. Die Magnetanordnung ist so ausgebildet, dass sich Nord- und Südpol so verzahnen, dass sich wellenförmige Racetracks herausbilden. Hierdurch ist es möglich, von der kompletten Targetoberfläche gleichmäßig zu sputtern.

## Beschreibung

Die Erfindung betrifft eine Magnetanordnung nach den Oberbegriffen der Patentansprüche 1 und 7.

Bei einer Sputteranlage wird im Vakuum ein Plasma in einer Sputterkammer erzeugt. Unter einem Plasma versteht man ein quasi-neutrales Vielteilchensystem in Form gasartiger Mischungen freier Elektronen und Ionen sowie eventuell neutraler Teilchen, d. h. Atome, Moleküle oder Radikale. Positive Ionen des Plasmas werden durch das negative Potential einer Kathode angezogen, die mit einem so genannten Target versehen ist. Auf diesem Target treffen die positiven Ionen auf und schlagen kleine Partikel heraus, die sich auf einem Substrat niederschlagen können. Das Herausschlagen dieser Partikel nennt man "Sputtern" oder Zerstäuben. Das Plasma enthält ionisierte Gase, die bei einem nicht-reaktiven Sputtern Edelgase, z. B. Argon, sein können. Bei reaktivem Sputtern wird z. B. Sauerstoff allein oder zusammen mit einem Edelgas verwendet.

Die für den Zerstäubungsprozess benötigten Ionen werden durch Zusammenstöße von Gasatomen und Elektronen in einer Glimmentladung erzeugt und mit Hilfe eines elektrischen Feldes in das die Kathode bildende Target beschleunigt.

Beim konventionellen DC- und HF-Sputtern tragen nur wenige Sekundärelektronen, die beim Zerstäuben des Targets emittiert werden, zur Ionisierung der Sputtergasatome bei.

Um den Sputtereffekt zu verbessern, werden in der Nähe des Targets Magnete eingesetzt, deren Magnetfeld das Plasma am Target hält. Durch das Zusammenwirken von magnetischem und elektrischem Feld bewegen sich die Ladungsträger im Plasma im Wesentlichen nicht mehr parallel zum elektrischen Feld, sondern auch quer dazu, wodurch sich zykloidenförmige Elektronenbahnen ergeben. Da die Ablenkradien der Elektronen aufgrund ihrer geringen Masse sehr viel kleiner als die der Ionen sind, konzentrieren sich die Elektronen vor der Targetoberfläche. Es ergibt sich dadurch eine viel höhere Wahrscheinlichkeit, Sputtergasatome durch Stöße mittels Elektronen zu ionisieren. Aufgrund der ExB-Drift der Elektronen - die Elektronen folgen einer Bahn, die Racetrack genannt wird - und der Konzentration des Plasmas vor der Targetoberfläche fliegen die Elektronen nicht mehr direkt zum Substrat, sodass dadurch die Aufheizung des Substrats reduziert wird.

Die viel schwereren Ionen fallen auf das Target, das als negative Elektrode bzw. Kathode wirkt, und zerstäuben dieses. Ionisierungen finden also im Wesentlichen dort statt, wo der magnetische Feldvektor parallel zur Targetoberfläche verläuft. Das Plasma ist hier am dichtesten und daher wird das Target hier am stärksten erodiert. Das Glimmentladungsplasma wird durch das Magnetfeld gewissermaßen eingeschlossen, und die Bahnlängen der Elektroden werden dadurch verlängert, dass die Elektronen Drehbewegungen um die magnetischen Feldlinien als Achse ausführen, wodurch die Zusammenstoßrate zwischen Gasatomen und Elektronen erhöht wird.

Um große Flächen zu beschichten, werden in der Regel Planar-Magnetrons verwendet. Diese weisen jedoch eine geringe Target-Ausnutzung auf, beispielsweise von 40 % oder weniger.

Neuerdings werden deshalb immer häufiger rotierende Zylinder-Magnetrons eingesetzt, die eine Target-Ausnutzung von 90 % und mehr aufweisen.

Ein Nachteil, den sowohl Zylinder-Magnetrons, die bisweilen auch Rohrkathoden genannt werden, als auch Planar-Magnetrons aufweisen, ist die ungleichmäßige Ausnutzung der Targets. Die Rohrkathoden werden an den Rändern weniger gesputtert, wo sich sogar Rückbeschichtungen bilden können. Bei den Planar-Magnetrons bilden sich so genannte Racetracks, d. h. Erosions-Vertiefungen, die mittelbar durch die Anordnung der Magnete in den Magnetrons hervorgerufen werden. Unmittelbar erzeugt werden diese Erosions-Vertiefungen durch die auftreffenden ionisierten Gasteilchen. Diese fallen örtlich ungleichmäßig auf das Target, das als negative Elektrode bzw. Kathode wirkt und als Zerstäuber dient. Die durch das Magnetfeld bestimmte Plasmabahn - die zu den Elektronenbahnen korreliert - bzw. der Racetrack begrenzt insbesondere die Target-Ausnutzung von Planar-Magnetrons, denn wenn das Target an einer Stelle durcherodiert ist, kann es nicht mehr verwendet werden, auch wenn es an anderen Stellen noch genügend Material aufweist. Obwohl im stationären Zustand auch bei einem Rohr-Magnetron ein Plasma-Racetrack entsprechend der Magnet-Konfiguration vorhanden ist, bildet sich bei dem rotierenden Target keine nutenförmige Vertiefung.

Neben der schlauchförmigen Racetrack-Erosion tritt bei den rechteckigen Planar-magnetrons mit geradem Racetrack noch ein so genannter Cross-Corner-Effekt auf, der ebenfalls die Ausnutzung des Targets begrenzt. Unter dem Cross Corner versteht man die diagonal einander gegenüberliegenden Ecken eines rechteckigen Magnetrons. Wenn sich das Magnetfeld in einer Endregion der Magnetron-Kathode von dem Magnetfeld im mittleren Bereich unterscheidet, z. B. schwächer ist, driften die Elektronen schneller in dieser Endregion als in der Mitte, d. h. sie gelangen sehr schnell in den Cross-Corner-Bereich. In diesem Bereich tritt hierdurch ein Elektronenstau auf, der eine dichtere Ionisierung bewirkt und damit wiederum eine verstärkte Erosion des Targets zur Folge hat (vgl. Q. H. Fan. L. Q. Zhou und J. J. Gracio, A cross-corner effect in a rectangular sputtering magnetron, J. Phys. D: Appl. Phys. 36 (2003), 244 - 251).

Es ist bereits eine Magnetron-Sputtereinrichtung bekannt, bei der doppel-T-förmige Magnete einer ersten Polarität von rechteckigen Rahmen-Magneten einer zweiten Polarität umgeben sind (US 5 458 759). Hierbei wird die Anordnung der Magnete benutzt, um eine möglichst gleichmäßige Abnutzung des Targets zu erreichen.

Ein anderes bekanntes Verfahren geht ebenfalls davon aus, dass die Anordnung der Magnete ursächlich für die Erosionen auf dem Target ist (DE 197 01 575 A1). Es wird dabei vorgeschlagen, ein Substrat in einer Richtung senkrecht zur Längsrichtung der Kathode zu befördern, wobei die Magnete der Kathode derart angeordnet sind, dass sie zwei geschlossene Schleifen eines sputternden Erosionsflächenbereichs bilden und in Richtung senkrecht zur Längsrichtung der Kathode hin- und herbewegt werden.

Weiterhin ist eine Sputtervorrichtung bekannt, welche mäanderförmig angeordnete Magnete aufweist (EP 0 105 407, Fig. 5). Hierdurch wird erreicht, dass ein vorbestimmter Plasmazerstäubungsbereich in Form einer gewundenen Elektronenbahn vorliegt, die eine relativ gleichmäßige Ausnutzung eines Targets gewährleistet. Bei dieser bekannten Sputtervorrichtung findet keine Relativbewegung von Target und Magnetsystem statt. Hierdurch kann eine Rückbeschichtung zwischen den einzelnen Mäanderschleifen auftreten und das Target - welches größer als das Substrat ist - ist nicht vollflächig sputterbar.

Bei einer anderen bekannten Magnetron-Zerstäubungskathode ist ein innenliegender magnetischer Südpol vorgesehen, der einen Mittelbalken aufweist, von welchem sich in gleichmäßigen Abständen voneinander angeordnete Zungen rechtwinklig nach außen erstrecken (EP 0 242 826 B1). Hierbei besteht der außenliegende Magnetnordpol aus einem rechteckigen Rahmen, von dessen beiden Längsseiten sich rechtwinklige Zungen nach innen erstrecken, welche jeweils so angeordnet sind, dass sie zwischen zwei Zungen des Südpols liegen. Hierdurch erreicht man ein mäanderförmiges Magnetfeld und damit eine mäanderförmige Erosionszone. Auch bei dieser Zerstäubungskathode gibt es keine Relativbewegung zwischen Target und Magnetsystem.

Der Erfindung liegt die Aufgabe zugrunde, großflächige Targets durch eine geeignete Führung der Erosionsschläuche optimal auszunutzen und die Targetoberfläche möglichst redepositionsfrei zu halten.

Diese Aufgabe wird gemäß den Merkmalen der Patentansprüche 1 oder 7 gelöst.

Die Erfindung betrifft somit eine Magnetanordnung für ein Planar-Magnetron, bei welcher ein erster Magnetpol einen zweiten Magnetpol umschließt. Diese Magnetanordnung wird linear in Längsrichtung zu einem Target um einen bestimmten Betrag bewegt und dann in entgegen gesetzter Richtung um den gleichen Betrag wieder zurückbewegt. Bei einer Ausführungsform erfolgt auch noch eine Bewegung senkrecht hierzu. Die Magnetanordnung ist so ausgebildet, dass sich Nord- und Südpol so verzahnen, dass sich wellenförmige Racetracks herausbilden. Hierdurch ist es möglich, von der kompletten Targetoberfläche gleichmäßig zu sputtern.

Der mit der Erfindung erzielte Vorteil besteht insbesondere darin, dass auch großflächige und ebene Targets mit nur einem Erosionsschlauch so überstrichen werden können, dass mehr als 50 % ihrer Oberfläche von den Erosionsschläuchen erfasst werden. Durch die Relativbewegung zwischen Target und Magnetsystem ergibt sich ein homogenes Erosionsprofil. Durch das leichte Ineinandergreifen von einander gegenüberliegenden Magnetpol-Elementen wird auch in der Mitte des Targets gesputtert.

Bei einer vorteilhaften Ausgestaltung der Erfindung können lange, breite Targets sogar mit nur einem Racetrack oder Erosionsschlauch überstrichen werden. Da die beiden Pole der Magnetanordnung hierbei in der Mitte leicht ineinander greifen, ist es möglich, mit nur einer Linearbewegung eine hohe Targetausnutzung und eine fast komplett rückbeschichtungsfreie Targetoberfläche zu erreichen. Nord- und Südpol sind dabei so relativ zueinander angeordnet, dass sich auf dem Target mäanderförmige Racetracks ergeben.

Zwei einander gegenüberliegende Mäander liegen dabei so dicht beieinander, dass bei einer Linear-Bewegung in Richtung der Targetlänge die Targetoberfläche gleichmäßig gesputtert wird. Der Bewegungshub beträgt dabei ± halber Mänderabstand.

Ausführungsbeispiele der Erfindung sind in den Zeichnungen dargestellt und werden nachfolgend näher beschrieben. Es zeigen:
- Fig. 1: eine Teildarstellung einer ersten Magnetanordnung in einem Planar-Magnetron;
- Fig. 2: eine Teildarstellung einer zweiten Magnetanordnung in einem Planar-Magnetron;
- Fig. 3: eine Teildarstellung einer dritten Magnetanordnung in einem Planar-Magnetron;
- Fig. 4: eine Darstellung einer Magnetanordnung zusammen mit einem Target und einem Substrat.

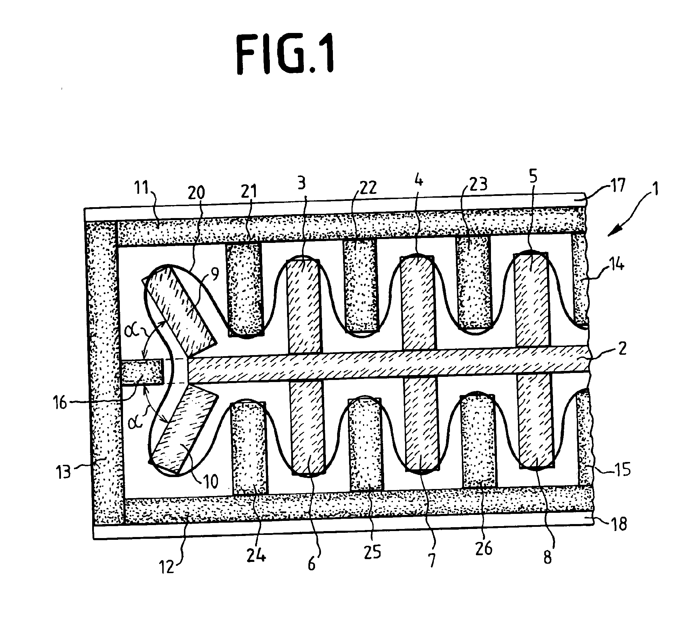

Die Fig. 1 zeigt eine Teildarstellung einer ersten Magnetkonfiguration 1 gemäß der Erfindung, mit der eine gleichmäßige Ausnutzung eines Targets ermöglicht wird. Dabei sind allerdings noch Bewegungen in zwei verschiedenen Bewegungsrichtungen notwendig. Zum einen muss das Magnetsystem über die Länge des Targets bewegt werden, und zum anderen ist eine zusätzliche Bewegung über die Targetbreite erforderlich, um in der Mitte keine Rückbeschichtung zu erhalten. Die in der Fig. 1 dargestellte Magnetkonfiguration 1 setzt sich auf der rechten - nicht dargestellten - Seite spiegelbildlich fort. Der magnetische Südpol der Magnetkonfiguration besteht aus einem quer verlaufenden Steg 2, an den sich parallel zueinander angeordnete und senkrecht auf dem Steg 2 stehende Arme 3 bis 8 anschließen.

An dem einen Ende des Stegs 2 sind zwei weitere Arme 9, 10 des magnetischen Südpols vorgesehen, deren Längsachse in einem Winkel α zur Längsachse des querverlaufenden Stegs 2 angeordnet ist. Der Winkel α beträgt hierbei etwa 60°. Am Ende der rechten und nicht dargestellten Seite des Stegs 2 befinden sich ebenfalls schräg gestellte Arme, die den Armen 9, 10 entsprechen, die aber nicht nach links, sondern nach rechts geneigt sind. Diese auf der rechten Seite befindlichen Arme sind also spiegelsymmetrisch zu den Armen 9, 10 angeordnet.

Der Nordpol der Magnetkonfiguration 1 ist rahmenförmig um den Südpol gelegt, wobei ein oberer und ein unterer Rahmenabschnitt 11, 12 sowie ein linker seitlicher Rahmenabschnitt 13 zu erkennen sind. Der rechte seitliche Rahmenabschnitt, der dem Abschnitt 13 entspricht, ist nicht dargestellt. In der Mitte des linken Rahmenabschnitts 13 ist ein Arm 16 vorgesehen, der dem linken Ende des Stegs 2 gegenüber liegt. Entsprechend ist auf der rechten Seite ein Arm vorgesehen, der dem Arm 16 entspricht.

Zwischen jeweils zwei Armen 9, 3; 3, 4; 4, 5; 10, 6; 6, 7; 7, 8 des Stegs 2 befindet sich eine Zunge 21 bis 23, 14 bzw. 24 bis 26, 15, die auf dem Rahmenabschnitt 11 bzw. 12 senkrecht steht und nach innen gerichtet ist.

Nord- und Südpol der Magnetkonfiguration 1 sind auf ihrer Rückseite mit einer Jochplatte 17, 18 verbunden. Mit der Linie 20 ist die Erosionsspur angedeutet, die auf der Rückseite eines Targets entsteht, das in der Fig. 1 nicht dargestellt ist.

Die Erosionsspur bzw. der Racetrack 20 bildet im statischen Betrieb, d. h. wenn sich die Magnetkonfiguration 1 und das Target nicht relativ zueinander bewegen, einen einzigen Mäander. Damit das Target optimal ausgenutzt wird, muss das Magnetjoch 17, 18 mit der Magnetkonfiguration 1 über die Targetlänge bewegt werden, um die Mäander auszumitteln. Außerdem ist noch eine Bewegung über die Targetbreite notwendig, damit in der Mitte des Targets keine Rückbeschichtung auftritt.

Die Anordnung der Magnete 9, 10, 16 dient zur Beseitigung oder Verminderung des Cross-Corner-Effekts. Nach einer längeren geraden Racetrack-Strecke können sich nach einer anschließenden Kurve Cross-Corner-Effekte ausbilden. Auf einem geradlinigen Racetrack alleine bilden sich keine Cross-Corner-Effekte aus. Diese treten nur an zwei gegenüberliegenden Stellen des Targets auf, wo die Elektronen aus der Kurve wieder auf eine gerade Stelle treffen (vgl. Fig. 7B in DE 197 01 575 A1). Bei der vorliegenden Erfindung ist der Racetrack jedoch keine längere Gerade, sondern er ist immer gekrümmt. Lässt man den Magnetarm 16 weg und setzt die Magnete 9 und 10 gerade, so ist in diesem Fall über die Targetbreite der Racetrack kurzzeitig gerade und es ist mit einem Cross-Corner-Effekt zu rechnen.

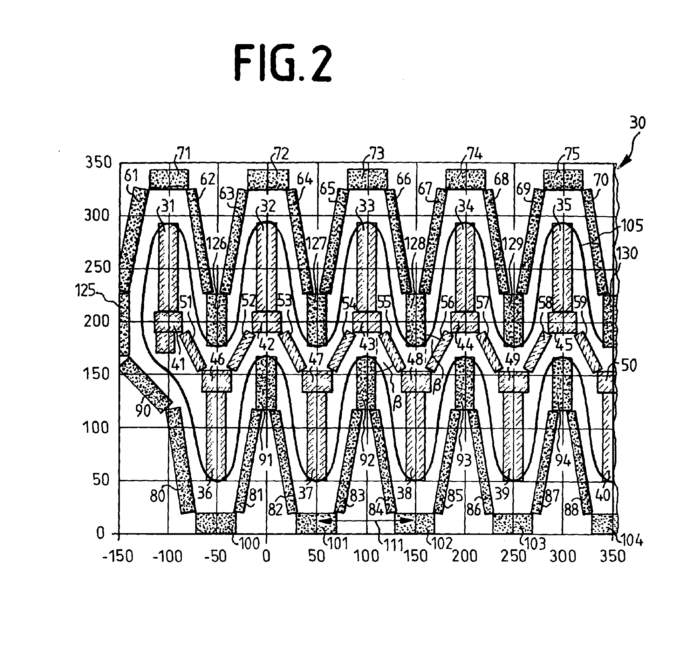

In der Fig. 2 ist eine zweite Magnetkonfiguration 30 dargestellt, bei der nur noch eine Bewegung entlang der Targetlänge erforderlich ist. Eine Bewegung in Targetbreite kann entfallen. Die Bewegung der Magnetkonfiguration 30 erfolgt dabei linear über die Länge eines Targets. Am Ende des Targets tritt eine Bewegungsumkehr ein.

Der eine Pol der Magnetkonfiguration 30, z. B. der Südpol, weist hierbei äquidistante obere Arme 31 bis 35 und äquidistante untere Arme 36 bis 40 auf. Die Längsachse der unteren Arme 36 bis 40 verlaufen parallel zu der Längsachse der oberen Arme 31 bis 35, sind aber seitlich in der Weise verschoben, dass sie durch einen Punkt verlaufen, der die Mitte zwischen der Längsachse der oberen Arme 31 bis 35 markiert.

Die jeweils nach innen gerichteten Enden der Arme 31 bis 35 bzw. 36 bis 40 schließen mit einem rechteckigen Block 41 bis 45 bzw. 46 bis 50 ab, an den sich Verbindungselemente 51 bis 59 anschließen, welche eine Verbindung zwischen den Blöcken 41 bis 45 und den Blöcken 46 bis 50 herstellen. Diese Verbindungselemente 51 bis 59 sind in einem Winkel β zu der Längsachse der Arme 31 bis 35 bzw. 36 bis 40 angeordnet.

Hierdurch sind alle Teile des Südpols magnetisch miteinander verbunden.

Der andere Pol, z. B. der Nordpol der Magnetkonfiguration 30 wird durch mehrere haubenförmige Teilmagnete gebildet, die jeweils einen Arm 31 bis 35 bzw. 36 bis 40 des Südpols umfassen. Diese Teilmagnete weisen jeweils zwei schräg zu der Mittelachse der Arme 31 bis 35 bzw. 36 bis 40 verlaufende Schenkel 61, 62 bzw. 63, 64 bzw. 65, 66 bzw. 67, 68 bzw. 69, 70 auf, deren obere Enden über einen Block 71 bzw. 72 bzw. 73 bzw. 74 bzw. 75 miteinander verbunden sind, dessen Längsachse horizontal verläuft. Die unteren Enden der Schenkel 61 bis 70 stehen ebenfalls mit Blöcken 125 bis 130 in Verbindung, deren Längsachse vertikal verläuft. Entsprechend den beschriebenen oberen Teilmagneten des Nordpols sind auch die unteren Teilmagnete angeordnet. Die Schenkel 80 bis 88 stoßen hierbei mit ihren Enden an Blöcke 90 bis 94 bzw. 100 bis 104. Die erstgenannten Blöcke 90 bis 94 sind dabei vertikal ausgerichtet, während die letztgenannten Blöcke 100 bis 104 horizontal ausgerichtet sind.

Der sich im statischen Zustand, d. h. ohne Relativbewegung zwischen Magnetkonfiguration 30 und Target ausbildende Racetrack ist mit 105 bezeichnet und bildet zwei übereinander liegende Wellenkurven, die sinus-ähnlich sind.

In der Fig. 2 ist außer dem Nord- und dem Südpol auch noch die Position des Nulldurchgangs der senkrechten Komponente des Magnetfelds auf der Targetoberfläche dargestellt. Die Richtung, in der die Magnetkonfiguration 30 relativ zu einem Target bewegt wird, ist durch einen Doppelpfeil 111 angegeben. Dieser zeigt an, dass die Bewegung nur in Längsrichtung des Targets erfolgt, und zwar einmal nach rechts und hierauf nach links etc. Die Hublänge beträgt dabei ± halber Mäanderabstand. Unter Mäanderabstand wird hierbei der Abstand von Kuppe zu Kuppe einer sinusförmigen Wellenlinie 105 verstanden. Die Größe des Doppelpfeils 111 entspricht ungefähr dem Mäanderabstand.

Die Angaben auf Ordinate und Abszisse sind in mm, die für die Erfindung ohne Bedeutung sind. Sie weisen lediglich auf die räumliche Größenanordnung einer realisierbaren Magnetanordnung hin.

Durch die zur Mittelachse unsymmetrische Bauweise der Magnetkonfiguration 30 wird auch im Mittelbereich gesputtert, jedoch entsteht eine Rückbeschichtung zwischen den Schleifen. Erst durch die Bewegung des Magnetfelds über der Targetlänge ergibt sich eine rückbeschichtungsfreie Targetoberfläche, mit Ausnahme der Randbereiche des Targets.

Bei der Magnetkonfiguration 30 entsteht oben und unten am Target ein Rückbeschichtungsbereich. Dieser Rückbeschichtungsbereich ist unerwünscht und kann beispielsweise durch Targets mit der Form eines Parallelogramms reduziert werden. Er kann aber auch durch Schiefstellen der Mäander reduziert werden.

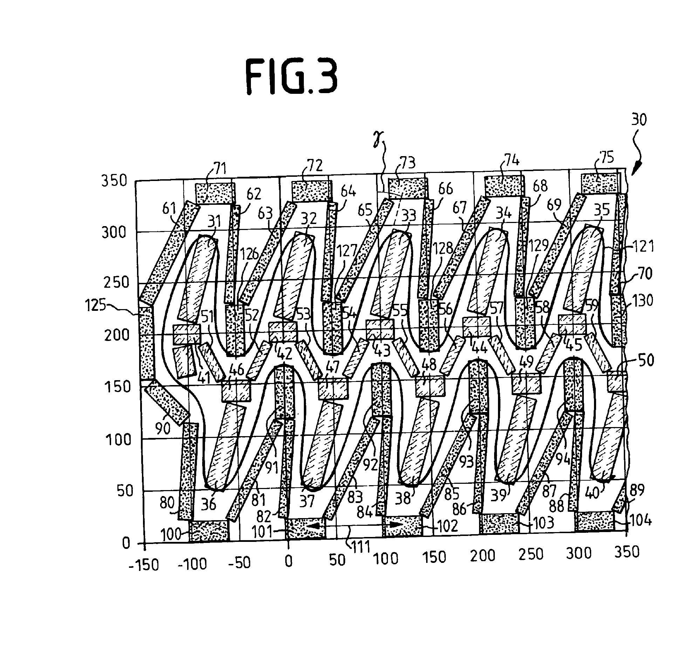

Eine Magnetkonfiguration 120, bei der die Mäander schiefgestellt sind, ist in der Fig. 3 gezeigt. Da die Zahl der Magnetelemente und ihre Grundanordnung die gleiche ist wie die gemäß Fig. 2, sind diese Magnetelemente mit denselben Bezugszahlen versehen wie in Fig. 2. Die Arme 31 bis 40 sind hierbei um einen Winkel γ gegenüber der Senkrechten geneigt. Hierdurch ergeben sich zwei übereinander angeordnete sinusförmige Wellenkurven als Racetrack 121. Durch das Schiefstellen der Mäander ist es möglich, die Rückbeschichtung an den beiden Enden des Targets zu reduzieren.

Die Magnetkonfiguration 120 der Fig. 3 wird in der gleichen Weise wie die Magnet-konfiguration 30 der Fig. 2 relativ zum Target bewegt.

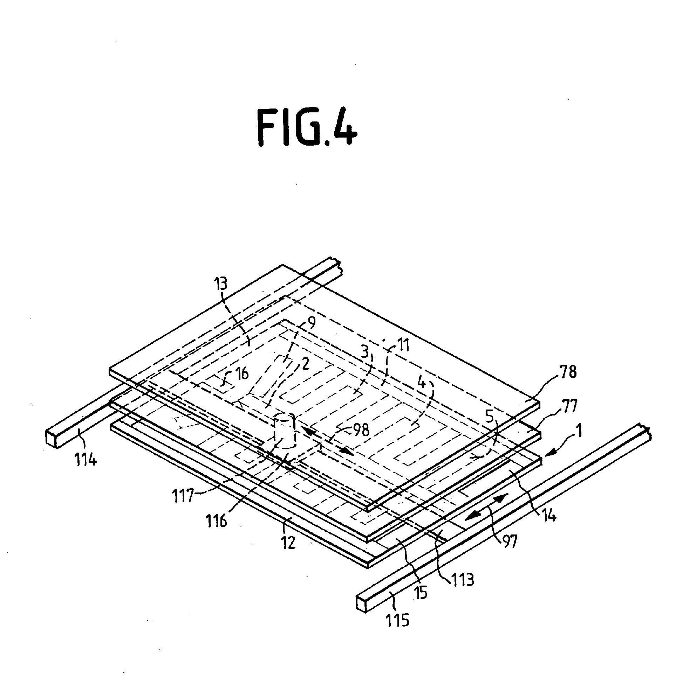

In der Fig. 4 ist eine schematische Darstellung einer Anordnung gezeigt, die außer der Magnetkonfiguration 1 auch noch ein Target 77 und ein Substrat 78 enthält. Die Magnetkonfiguration ist die gleiche wie in Fig. 1, weshalb die einzelnen Magnetteile auch mit den gleichen Bezugszeichen versehen sind.

Target 77 und Substrat 78 sind in einer nicht dargestellten Sputterkammer ortsfest angeordnet. Die Magnetkonfiguration 1 mit dem Joch 17, 18 ist dagegen unterhalb des Targets 77 in Richtung der Pfeile 97, 98 bewegbar. Hierfür ist eine Trägerplatte 113 vorgesehen, die an ihren Enden in Schienen 114, 115 geführt und mit einem nicht dargestellten Antrieb verbunden ist. Auf dieser Trägerplatte 113 ist ein Schlitten 116 angeordnet, der über eine Säule 117 die Magnetkonfiguration 1 trägt. Da der Schlitten 116 in Richtung des Pfeils 98 bewegbar ist, kann die Magnetkonfiguration 1 relativ zu dem Target 77 beliebig verschoben werden.

Bei den vorstehend beschriebenen Ausführungsbeispielen der Erfindung sind die Targets länger als der Magnetaufbau, da die Magnete über die Targetlänge bewegt werden. Die Targetbreite ist jedoch geringer als die Breite der Magnetanordnung. Die Größe des Targets wird von der Größe und Form des Racetracks und der Bewegung bestimmt.

## Patentansprüche

1. Magnetanordnung für ein Planar-Magnetron, bei welcher ein erster Magnetpol einen zweiten Magnetpol umschließt, **dadurch gekennzeichnet, dass** der zweite Magnetpol einen linearen Steg (2) enthält, an dessen Enden jeweils zwei in einem Winkel (α) zur Längsachse des Stegs (2) angeordnete Arme (9, 10) vorgesehen sind.

2. Magnetanordnung nach Anspruch 1, **dadurch gekennzeichnet, dass** der erste Magnetpol ein rechteckiger Rahmen (11 bis 13) ist, der mehrere Arme (16, 21 bis 23; 15, 24 bis 26) aufweist, die auf den Steg (2) des zweiten Magnetpols gerichtet sind.

3. Magnetanordnung nach Anspruch 2, **dadurch gekennzeichnet, dass** zwei der Arme (16) des Rahmens (11 bis 13) auf der gedachten Verlängerung der Längsachse des Stegs (2) liegen und einen Abstand von diesem Steg (2) besitzen.

4. Magnetanordnung nach Anspruch 1, **dadurch gekennzeichnet, dass** der lineare Steg (2) mehrere senkrecht auf seiner Längsachse stehende Arme (3 bis 8) aufweist.

5. Magnetanordnung nach einem oder mehreren der vorstehenden Ansprüche, **dadurch gekennzeichnet, dass** Längsachsen von Armen (21 bis 23; 15, 24 bis 26) des Rahmens (11 bis 13) und Längsachsen von Armen (3 bis 8) des Stegs (2) parallel zueinander verlaufen.

6. Magnetanordnung nach einem oder mehreren der vorstehenden Ansprüche, **dadurch gekennzeichnet, dass** Arme (21 bis 23; 15, 24 bis 26) des Rahmens (11 bis 13) und Arme (3 bis 8) des Stegs (2) ineinander greifen.

7. Magnetanordnung für ein Planar-Magnetron, bei welcher ein erster Magnetpol einen zweiten Magnetpol umschließt und der zweite Magnetpol eine erste Gruppe von Armen (31 bis 35) aufweist, die in eine erste Richtung verlaufen, sowie eine zweite Gruppe von Armen (36 bis 40), die in eine zur ersten Richtung entgegengesetzte Richtung verlaufen, **dadurch gekennzeichnet, dass** die Längsachse der ersten Gruppe von Armen (31 bis 35) gegenüber der Längsachse der zweiten Gruppe von Armen (36 bis 40) derart versetzt ist, dass die Längsachse eines Arms (z. B. 34) der ersten Gruppe zwischen den Längsachsen zweier Arme (z. B. 38, 39) der zweiten Gruppe verläuft.

8. Magnetanordnung nach Anspruch 7, **dadurch gekennzeichnet, dass** die Arme (31 bis 35) der ersten Gruppe äquidistant angeordnet sind.

9. Magnetanordnung nach Anspruch 7, **dadurch gekennzeichnet, dass** die Arme (36 bis 40) der zweiten Gruppe äquidistant angeordnet sind.

10. Magnetanordnung nach Anspruch 7, **dadurch gekennzeichnet, dass** die erste Gruppe von Armen (31 bis 35) und die zweite Gruppe von Armen (36 bis 40) über schräg verlaufende Stege (51 bis 59) miteinander verbunden sind.

11. Magnetanordnung nach Anspruch 10, **dadurch gekennzeichnet, dass** die schräg verlaufenden Stege (51 bis 59) über Blöcke (41 bis 45 bzw. 46 bis 50) mit den Armen (31 bis 35; 36 bis 40) in Verbindung stehen.

12. Magnetanordnung nach Anspruch 7, **dadurch gekennzeichnet, dass** der erste Pol eine erste Gruppe von schräg gestellten Armen (61 bis 70) aufweist, von denen je zwei (z. B. 63, 64) ein satteldachförmiges Element bilden, wobei das jeweils eine Ende eines Arms (z. B. 64) mit einem ersten Block (z. B. 127) und das jeweils andere Ende eines Arms (z. B. 64) mit einem zweiten Block (z. B. 72) in Berührung stehen.

13. Magnetanordnung nach Anspruch 12, **dadurch gekennzeichnet, dass** die Längsachse des ersten Blocks (127) senkrecht zur Längsachse des zweiten Blocks (72) verläuft.

14. Magnetanordnung nach Anspruch 12, **dadurch gekennzeichnet, dass** ein satteldachförmiges Element (z. B. 65, 66) des ersten Pols einen Arm (33) des zweiten Pols umfasst.

15. Magnetanordnung nach Anspruch 12, **dadurch gekennzeichnet, dass** die beiden schräg gestellten Arme (z. B. 65, 66) eines satteldachförmigen Elements spiegelsymmetrisch zueinander angeordnet sind.

16. Magnetanordnung nach Anspruch 12, **dadurch** gekennzeichent, dass die beiden schräg gestellten Arme (z. B. 65, 66) eines satteldachförmigen Elements jeweils verschiedene Neigungswinkel zu einer durch einen Block (z. B. 128) gehenden Längsachse aufweisen.

17. Magnetanordnung nach Anspruch 7, **dadurch gekennzeichnet, dass** die Arme (31 bis 35, 36 bis 40) des zweiten Magnetpols verschiedene Neigungswinkel zu einer durch einen Block (z. B. 128) des ersten Magnetpols gehenden Längsachse aufweisen.

18. Magnetanordnung nach Anspruch 1 oder Anspruch 7, **dadurch gekennzeichnet, dass** die Magnetanordnung Teil eines Magnetrons einer Sputteranlage ist.

19. Magnetanordnung nach Anspruch 18, **dadurch gekennzeichnet, dass** die Magnetanordnung in der Nähe eines Targets (77) angeordnet ist.

20. Magnetanordnung nach Anspruch 19, **dadurch gekennzeichnet, dass** das Target (77) einem Substrat (78) gegenüberliegt.

21. Magnetanordnung nach den Ansprüchen 1 oder 7, **dadurch gekennzeichnet, dass** die Magnetanordnung relativ zu einem Target (77) bewegbar ist.

22. Magnetanordnung nach Anspruch 1, **dadurch gekennzeichnet, dass** die Magnetanordnung (1) in x- und in y-Richtung relativ zum Target (77) bewegbar ist.

23. Magnetanordnung nach Anspruch 22, **dadurch gekennzeichnet, dass** die Magnetanordnung (1) vor- und zurückbewegbar ist.

24. Magnetanordnung nach Anspruch 7, **dadurch gekennzeichnet, dass** die Magnetanordnung (30) in x-Richtung und relativ zu einem Target (77) bewegbar ist.

25. Magnetanordnung nach Anspruch 24, **dadurch gekennzeichnet, dass** die Magnetanordnung (30) vor- und zurückbewegbar ist.

## Geänderte Patentansprüche

### Geänderte Patentansprüche gemäss Regel 86(2) EPÜ.

**1.** Magnetanordnung für ein Planar-Magnetron, bei welcher ein erster, als rechteckiger Rahmen ausgebildeter Magnetpol einen zweiten, als linearer Steg ausgebildeten Magnetpol enthält, wobei der lineare Steg mehrere senkrecht auf seiner Längsachse stehende Arme aufweist, **dadurch gekennzeichnet, dass** an den Enden des Stegs (2) jeweils zwei in einem Winkel (α) von etwa 60° zur Längsachse des Stegs (2) verlaufende Arme (9, 10) vorgesehen sind.
